Europäisches Patentamt

European Patent Office

Office européen des brevets

(11) Numéro de publication: **0 168 631**
**B1**

(12) **FASCICULE DE BREVET EUROPEEN**

(45) Date de publication du fascicule du brevet: **07.12.88**

(51) Int. Cl.⁴: **H 04 Q 3/52, H 03 F 3/72**

(21) Numéro de dépôt: **85107214.0**

(22) Date de dépôt: **13.06.85**

(54) Sélecteur opto-électronique.

(30) Priorité: **15.06.84 FR 8409414**

(43) Date de publication de la demande:
**22.01.86 Bulletin 86/04**

(45) Mention de la délivrance du brevet:
**07.12.88 Bulletin 88/49**

(84) Etats contractants désignés:
**BE DE FR GB IT LU NL SE**

(56) Documents cités:
**WO-A-80/01028**

**OPTICAL COMMUNICATION, 9th EUROPEAN CONFERENCE ON OPTICAL COMMUNICATION, 23-26 octobre 1983, pages 331-334, Elsevier Science Publishers B.V., Genève, CH; P.B. HESDAL et al.: "A multi service single fibre subscriber network with wideband electro-optical switcing"**

**RADIO FERNSEHEN ELEKTRONIK, volume 30, no. 3, mars 1981, pages 184,185, Berlin DD; G. HALT: "Elektronischer Schalter mit Operationsverstärkereigenschaften"**

(73) Titulaire: **ALCATEL CIT**
**33, rue Emeriau**
**F-75015 Paris (FR)**

(72) Inventeur: **Faugeras, Philippe**
**11, rue de Sully**
**F-92100 Boulogne Billancourt (FR)**
Inventeur: **Tribet, Daniel**
**4, Chemin Vert Villemoisson sur Orge**
**F-91360 Epinay sur Orge (FR)**

(74) Mandataire: **Weinmiller, Jürgen et al**
**Lennéstrasse 9 Postfach 24**
**D-8133 Feldafing (DE)**

Courier Press, Leamington Spa, England.

**Description**

La présente invention est du domaine des transmissions optiques. Elle a pour objet un sélecteur opto-électronique, du type à P entrées pour P signaux optiques différents et à une sortie de signal électrique correspondant à l'un des P signaux optiques d'entrée souhaité. De tels sélecteurs opto-électroniques s'appliquent tout particulièrement dans un ensemble de diffusion de P programmes vers N abonnés pour la réception par chacun de ces N abonnés de l'un des programmes souhaité.

D'une manière générale, un ensemble de diffusion optique de P programmes vers N abonnés met en oeuvre deux fonctions, l'une dite de distribution qui consiste à transmettre chacun des programmes N fois, pour les N abonnés, et l'autre dite de sélection qui consiste à ne transmettre sur chacune des N liaisons d'abonnés que celui des programmes souhaité par l'abonné concerné, parmi les P programmes mis à sa disposition. Dans un tel ensemble de diffusion, la fonction de distribution des P programmes pour les N abonnés peut être réalisée à partir de guides d'ondes, tels que des fibres optiques ou des guides intégrés dans un support, ou à partir de systèmes optiques par exemple à lentilles. La fonction de sélection de l'un des programmes parmi les P pour chaque abonné peut être réalisée notamment à partir de photodiodes.

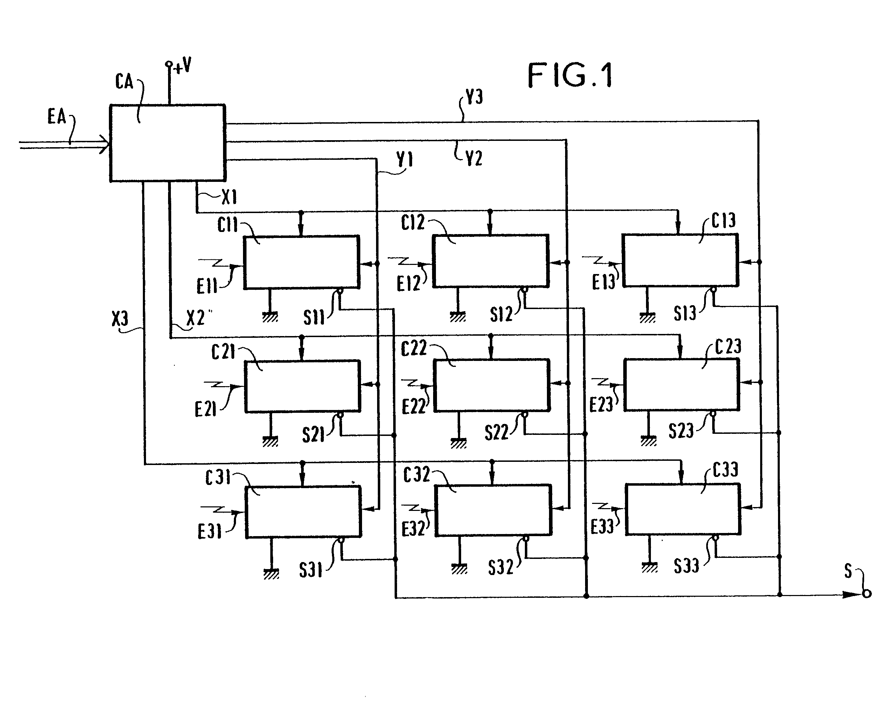

L'article intitulé "A High speed optoelectronic matrix using heterojonction switching photodiode" de H.Hara et autres, publié dans IEEE Journal Quantum Electronics, vol, QE-17 n° 8, août 1981, pages 1539 à 1545, donne en regard de la figure 1 qui y est présentée, le principe de réalisation d'une matrice de commutation opto-électonique à photodiodes. Dans cet exemple, on utilise comme élément de commutation, l'alimentation individuelle de chaque photodiode réalisée à travers un interrupteur commandé associé à la photodiode pour obtenir la fonction de sélection d'un signal d'entrée parm plusieurs sur une sortie de la matrice. Ainsi, lorsque l'une des photodiodes est reliée au pôle positif de l'alimentation, cette photodiode convertit le signal optique reçu, ou photons reçus, en courant électrique qui est détecté et transmis sur la sortie commune à la colonne de photodiodes. Par contre lorsque l'une des photodiodes est reliée au pôle négatif de l'alimentation, cette photodiode polarisée en direct est traversée par un courant électrique, de l'ordre de 10 mA, qui empêche toute détection de signal optique reçu. Ce passage de courant est nécessaire afin d'anuler l'effet photovoltaïque de la photodiode.

L'article intitulé "A multi service single fibre subscriber network with wideband electro-optical switchwing" de P.B. Hesdahl et autres présenté à ECOC 83-9 th European Conference on Optical Communication et publié par Elsevier Science Publishers B.V (North-Holland), 1983 p.331 à 334 donne aussi le principe de réalisation d'une matrice de sélection opto-électronique à photodiodes chacune suivie d'un préamplificateur associé. Dans cette dernière matrice, la commande de commutation individuelle des photodiodes est appliquée à la fois sur l'alimentation de chaque photodiode et de son préamplificateur associé. Cette configuration, comme celle de la matrice précédente, utilise des composants discrets et réalise un décodage ponctuel des signaux transmis aux points d'intersection; en outre, par rapport, à la matrice précédente, elle permet un meilleur isolement entre photodiodes et évite une consommation électrique des composants lors d'une non détection de signal reçu souhaitée.

On connaît aussi, notament par les brevets français n° 2441309 et n° 2445675, un sélecteur opto-électonique à photodiodes associées à des transistors de commutation pour leur adressage sous forme matricielle. Dans un tel arrangement, les photodiodes sont identifiées par l'intersection de lignes et de colonnes. Les photodiodes reçoivent individuellement les signaux optiques d'entrée du sélecteur, leurs sorties de signal électrique sont reliées en commun à celle du sélecteur. Chaque photodiode est polarisable à partir d'une même source de polarisation. La polarisation de chaque photodiode est commandée par deux transistors MOS en série. L'un de ces transistors, affecté aux photodiodes d'une même ligne, est déblocable par une tension appliquée sur sa grille par une commande de sélection de la ligne correspondant à la photodiode concernée. L'autre transistor, affecté à une seule photodiode, est déblocable par une tension appliquée sur sa grille par une commande de sélection de la colonne convenable pour cette photodiode, cette tension de commande de sélection de colonne étant appliquée en commun aux grilles de tous les transistors affectés aux photodiodes de cette colonne.

Lorsque le photodétecteur ainsi sélectionné reçoit un signal lumineux,, un courant est transmis à la sortie de signal électrique. Dans un tel sélecteur, il est impératif que les photodiodes non sélectionnées ne puissent écouler les charges créées lorsqu'elles reçoivent un signal optique. Ceci implique que les transistors affectés aux colonnes non concernées comme ceux affectés aux lignes non concernées, soient effectivement bloqués, c'est-à-dire aient un courant de fuite nul ou très faible pcur ne pas transmettre de courant perturbateur provenant de photodiodes non sélectionnées. En conséquence, cette solution, de conception intéressante par la réduction des liaisons de commande qu'elle permet du fait de l'adressage matriciel des photodiodes, demeure cependant de réalisation pratique difficile en particulier en regard de l'impossibilité d-obtenir sur un même substrat une photodiode de bonne qualité (sensibilité de l'ordre de 0,4 A/W et capacité de foncticn inférieure à 0,3 pF) et des transistors MOS présentant un rapport de valeurs de résistance au blocage et au déblocage de $10^7$.

La présente invention a donc pour but de réaliser un sélectsur opto-électronique du type à adressage matriciel de photodétecteurs mais présentant en outre une plus grande insensibilité au bruit et un meilleur isolement entre canaux que la structure connue précitée de ce type et se prêtant aisément à une intégration.

Elle a donc pour objet un sélecteur opto-électronique à photodétecteurs à adressage matriciel, dans lequel les entrées individuelles de signal optique des photodétecteurs constituent des entrées de signal optique du sélecteur et les sorties individuelles de signal électrique des photodétecteurs sont reliées en commun à une sortie de signal électrique du sélecteur, caractérisé par le fait que lesdits photodétecteurs sont suivis d'amplificateurs individuels chacun alimenté à tension constante à partir d'une source de polarisation au moyen d'un sélecteur dit de lignes de la matrice et à courant constant à partir d'une source de courant propre audit amplificateur considéré et déblocable au moyen d'un sélecteur dit de colonnes de la matrice, lesdits amplificateurs ayant leurs étages d'amplification à structure différentielle.

L'invention sera décrite ci-après en regard des schémas de réalisation donnés à titre d'exemple dans le dessin ci-annexé. Dans ce dessin:

- la figure 1 est un schéma illustrant un sélecteur opto-électronique à adressage matriciel du type de celui visé par la présente invention,

- la figure 2 est un schéma électrique d'une cellule opto-électronique selon l'invention, rentrant dans le sélecteur opto-électronique de la figure 1, aux points d'intersection de la matrice.

La figure 1 représente un sélecteur opto-électronique à adressage matriciel, de type à P entrées de signal optique et une sortie de signal électrique; dans l'exemple illustré il est à 9 entrées de signal optique référencées E11, E12, E13, E21, ...., E33, la sortie de signal électique est référencée S. Il comporte 9 cellules opto-électroniques agencées selon une disposition matricielle 3 X 3, référencées C11, C12, C13, C21, ..., C33, comportant chacune un photodétecteur, non illustré, dont l'entrée de signal optique constitue l'une des entrées E11 à E33 du sélecteur. Chaque cellule opto-électronique a une sortie de signal électrique référencée par s11, s12, s13, s21, ..., s33, selon la cellule considérée, reliée directement à la sortie commune S du sélecteur. Chaque cellule est en outre reliée à la masse.

Ce sélecteur opto-électronique est à adressage matriciel. Il comporte à cet effet deux réseaux de liaisons d'adressage, X1, X2 et X3 pour les liaisons d'adressage de lignes et Y1, Y2, Y3 pour les liaisons d'adressage de colonnes, reliées aux cellules selon le rang de la ligne et celui de la colonne auxquelles appartient chacune des cellules, et un circuit sélecteur de ligne et sélecteur de colonne ou circuit d'adressage CA. Ce circuit CA est relié à une source extérieure d'alimentation +V et reçoit sur une entrée de commande d'adressage EA un signal de commande de sélection de l'une des cellules à partir duquel il transmet la tension +V à cette cellule simultanément par la ligne et la colonne auxquelles elle appartient.

Bien entendu toute autre disposition matricielle des cellules peut être adoptée sans entraîner de modification du principe de sélection de l'une des cellules parmi l'ensemble des cellules.

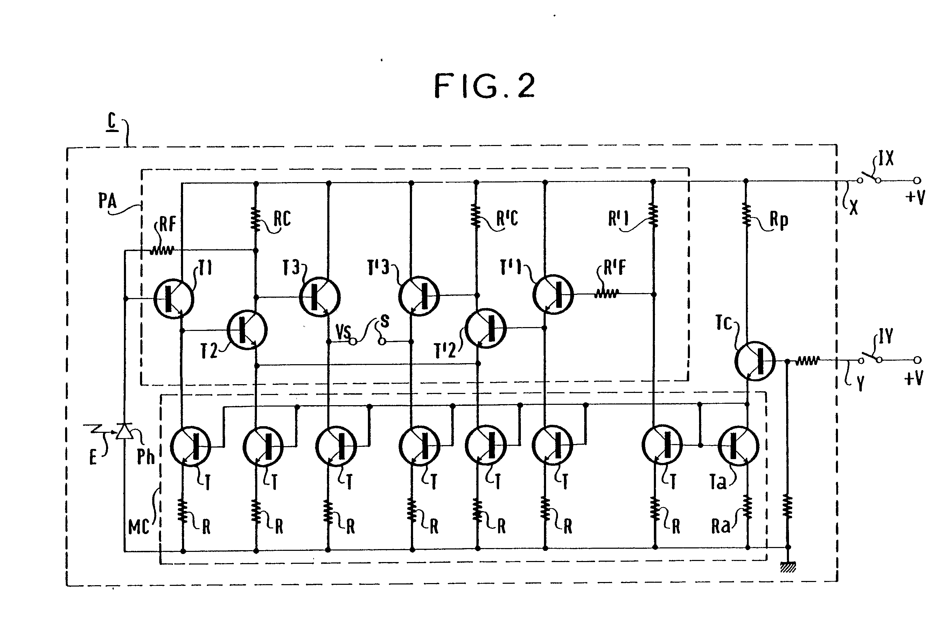

Dans la figure 2 on a représenté le schéma électrique de l'une quelconque des cellules opto-électroniques selon l'invention désignée par C, rentrant dans le sélecteur de la figure 1, en tant que composant élémentaire du sélecteur. Ce composant est de taille de l'ordre de, $(500 \times 500)$ $\mu$ m$^2$ pour une photodiode de face sensible de $(200 \times 200)$ $\mu$ m$^2$.

Cette cellule C comporte essentiellement un photodétecteur Ph suivi d'un préamplificateur PA et un miroir de courant MC utilisé pour l'alimentation du préamplificateur réalisée à partir de la liaison d'adressage de ligne X et de la liaison d'adressage de colonne Y qui correspondent à cette cellule C dans le montage de la figure 1.

On notera que dans le schéma illustré de cette cellule, tous les transistors qui apparaissent sont à titre d'exemple, de type NPN.

La photodiode Ph est reliée à la masse et à travers des résistances RF et RC à la liaison d'adressage de ligne X, pour sa polarisation.

Le préamplificateur PA est à structure symétrique et comporte trois étages: un étage d'entrée, un étage intermédiaire, d'amplification, à structure différentielle et un étage de sortie. Chaque étage est monté pour son alimentation entre la liaison d'adressage de ligne X et deux branches du miroir de courant MC commandé à partir de la liaison Y.

L'étage d'entrée est constitué par deux transistors T1 et T'1 montés en collecteur commun. Le transistor T1 a sa base reliée à la connexion commune à la photodiode Ph et à la résistance RF, son collecteur est relié à la liaison X et son émetteur à l'une des branches du miroir de courant. Le transistor T'1 a son émetteur relié à sa propre branche du miroir de courant, sa base est reliée à travers une résistance R'F d'une part par une résistance R'1 à la liaison X et d'autre part à une autre branche du miroir de courant de maière à lui assurer une polarisation aussi identique que possible à celle du transistor T1. Cet étage d'entrée sert à diminuer le bruit aux hautes fréquences.

L'étage intermédiaire est constitué par deux transistors amplificateurs T2 et T'2 montés en émetteur commun et formant une paire différentielle. Les émetteurs de ces transistors T2 et T'2 sont reliés par une liaison commune à deux branches du miroir de courant affectées à cet étage intermédiaire, la base de chacun d'eux est reliée à l'émetteur du transistor T1 ou T'1, de l'étage d'entrée. Le collecteur du transistor T2 est relié à la connexion commune aux résistances RC et RF, la résistance RF le reliant à la photodiode Ph étant ainsi connectée en contre-réaction sur le transistor T2 pour la constitution d'un montage amplificateur de type à transimpédance. Le collecteur du transistor T'2 est relié à la liaison X par une résistance R'C.

L'étage de sortie est constitué par deux transistors T3 et T'3 montés en collecteur commun. Ces transistcrs ont chacun leur base reliée, au collecteur du transistor T2 ou T'2 de la partie correspondante de l'étage d'amplification, leurs émetteurs sont reliés à leurs propres branches de miroir de courant et définissent entre eux une liaison bifilaire correspondant à la sortie s de cette cellule, qui sera reliée à la sortie S du sélecteur de la figure 1. Cet étage de sortie permet d'avoir une faible 'impédance de sortie et donc une bonne adaptation de la cellule C aux circuits suivants dans la liaison de transmission de signal alors établie avec l'abonné correspondant à partir de la sortie S du sélecteur.

Le miroir de courant MC a une brache de commande et sept branches commandées. Les branches commandées sont identiques entre elles, elles comportent chacune un transistor T dont l'espace collecteur-émetteur est, monté d'une part en série avec l'espace collecteur-émetteur du transistor du préamplificateur auquel cette branche est affectée en ce qui concerne six d'entre elles et avec la résistance R'l en ce qui concerne la septième et d'autre part en série avec une résistance R par ailleurs mise à la masse. La branche de commande comporte un transistor Ta dont l'émetteur est relié à la masse par une résistance Ra et dont le collecteur, connecté à la propre base de ce transistor Ta ainsi qu'aux bases de tous les transistors T, est en outre relié à l'émetteur d'un transistor de commutation Tc dont le collecteur est relié à la liaison d'adressage de ligne X par une résistance de polarisation Rp et dont la base est reliée à travers un pont résistif diviseur de tension d'une part à la liaison d'adressage de colonne Y et d'autre part à la masse.

Dans ce montage de la figure 2, on a en outre schématisé par un interrupteur IX reliant la liaison X à la source d'alimentation +V et un interrupteur IY reliant la liaison Y à la source d'alimentation +V la présence ou l'absence, selon que ces interrupteurs scnt fermés ou ouverts, d'une tension de polarisation et d'une tension de commande sur les liaisons X et Y correspondantes.

En fonctionnement, l'alimentation générale +V étant transmise par la liaison X à la cellule C (interrupteur IX fermé) la photodiode Ph est polarisée à travers les résistances RC et RF. Le signal de commande, également +V, étant alors absent sur la liaison Y (interrupteur IY ouvert) le transistor Tc est bloqué, aucun courant ne circule donc dans les transistors Tc, Ta et les transistors T des différentes branches commandées du miroir de courant MC. Dans ces oonditions les transistors T1, T2 et T3 et T'1, T'2 et T'3 ne sont pas polarisés et aucun courant ne traverse le préamplificateur. Bien que la photodiode soit polarisée aucun signal ne peut apparaître sur la sortie de la cellule. La consommation de la cellule se limite aux courants de fuite des transistors et de la photodiode (de l'ordre du nanoampère).

L'alimentation générale +V étant présente sur la liaison X (interrupteur IX fermé) et simultanément le signal de commande +V sur la liaison Y (interrupteur IY fermé), la photodiode Ph est polarisée et, par le transistor Tc passant, les différentes branches du miroir de courant MC sont activées. Un courant circule alors dans les différents étages du préamplificateur qui délivre en sortie un signal Vs traduisant le signal optique reçu par la face sensible de la photodiode sélectionnée.

Si la liaison X n'est pas alimentée, aucune information ne peut être transmise en sortie s de la cellule et celle-ci ne consomme pas d'énergie.

La structure des cellules permet de réaliser un sélecteur optoélectronique à adressage matriciel présentant une grande insensibilité au bruit, ayant un excellent isolement entre les sorties individuelles des cellules et dont la consommation d'énergie est limitée sensiblement à celle de la seule cellule sélectionnée. De plus, ce sélecteur, réalisable à l'aide de photodiodes et de transistors bipolaires, se prête aisément à une intégration.

**Revendications**

1. Sélecteur opto-électronique à photodétecteurs à, adressage matriciel, dans lequel les entrées individuelles (E11-E33) de signal optique des photodetecteurs constituent des entrées de signal optique du sélecteur et les sorties individuelles de signal électrique des photodétecteurs sont reliées en commun à une sortie (S) de signal électrique du sélecteur, caractérisé par le fait que lesdits photodétecteurs (Ph) sont suivis d'amplificateurs individuels (PA) chacun alimenté à tension constante à partir d'une source de polarisation (+V) au moyen d'un sélecteur dit de lignes (CA) de la matrice et à courant constant à partir d'une source de courant (MC) propre audit amplificateur ccnsidéré et déblocable au moyen d'un sélecteur dit de colonnes (CA) de la matrice, lesdits amplificateurs (PA) ayant leurs étages d'amplification à structure différentielle.

2. Sélecteur opto-électronique selon la revendication 1, caractérisé par le fait que les photodétecteurs (Ph) sont polarisables à partir de ladite source de polarisation (+V), au moyen du sélecteur dit de lignes (CA), chacune à travers des résistances individuelles (RF, RC) dont l'une (RF) est montée en résistance de contre réaction dans ledit amplificateur (PA) suivant le photodétecteur concerné.

3. Sélecteur opto-électronique selon l'une des revendications 1 et 2, caractérisé par le fait que lesdits amplificateurs (PA) sont chacun à plusieurs étages alimentés par des branches individuelles d'un miroir de courant (MC) formant la source de courant de l'amplificateur considéré.

4. Sélecteur opto-électronique selon la revendication 3, caractérisé par le fait que ledit miroir de courant (MC) associé à chaque amplificateur est activé par un transistor de commutation (Tc) polarisé à partir de ladite source de polarisation (+V) au moyen du sélecteur dit de lignes (CA) et commandé à partir de cette source de polarisation (+V) au moyen du sélecteur dit de colonnes (CA).

**Patentansprüche**

1. Optoelektronischer Wähler mit Photodetektoren und Matrixadressierung bei dem die Einzeleingänge (E11-E33) für das optische Signal der Photodetektoren die Eingänge für das optische Signal des Wählers, und die Einzelausgänge für das elektrische Signal der Photodetektoren gemeinsam an einen Ausgang (S) des elektrischen Signals des Wählers angeschlossen sind, dadurch gekennzeichnet, daß den Photodetektoren (Ph) Einzelverstärker (PA) nachgeschaltet sind, von denen jeder mit konstanter Spannung aus einer Vorspannungsquelle (+V) durch einen Wähler der Matrix, Zeilenwähler (CA) genannt, und mit konstantem Strom aus einer Stromquelle (MC) innerhalb des betrachteten Verstärkers versorgt wird, der durch einen Wähler der Matrix, Spaltenwähler (CA) genannt, freigegeben werden kann, wobei die Verstärkungsstufen der Verstärker (PA) Differentialstruktur besitzen.

2. Optoelektronischer Wähler nach Anspruch 1, dadurch gekennzeichnet, daß die Photodetektoren (Ph) durch die Vorspannungsquelle (+V) mit Hilfe des Zeilenwählers (CA) vorgespannt werden, und zwar jeder über Einzelwiderstände (RF, RC), von denen einer (RF) als negativer Rückkoplungswiderstand in dem dem betrachteten Photodetektors nachgeschalteten Verstärkers (PA) geschaltet ist.

3. Optoelektronischer Wähler nach einem der Ansprüche 1 und 2, dadurch gekennzeichnet, daß jeder der Verstärker (PA) aus mehreren Stufen besteht, welche durch die Einzelzweige eines Stromspiegelskreises (MC) versorgt werden, der die Stromquelle des betrachteten Verstärkers bildet.

4. Optoelektronischer Wähler nach Anspruch 3, dadurch gekennzeichnet, daß der mit jedem Verstärker verbundene Stromspiegelkreis (MC) durch einen Schalttransistor (Tc) aus der Vorspannungsquelle (+V) mit Hilfe des Zeilenwählers (CA) vorgespannt wird, und daß er aus der Vorspannungsquelle (+V) mit Hilfe des Spaltenwählers (CA) gesteuert wird.

**Claims**

1. An opto-electronic selector having matrix-addressed photodetectors, in which the individual optical signal inputs (E11-E33) of the photodetectors constitute the optical signal inputs of the selector, and the individual electrical signal outputs of the photodetectors are connected in common to an electrical signal output (S) of the selector, characterized in that the photodetectors (Ph) are output-connected to individual amplifiers (PA), each of which is powered at constant voltage by a bias voltage source (+V) via a selector (CA), referred to as "matrix line selector", and at constant current by a current source (MC) belonging to the considered amplifier (A) and activated by a selector, referred to as "matrix column selector", the amplification stages of the amplifiers (PA) being of differential structure.

2. An opto-electronic selector according to claim 1, characterized in that the photodetectors (Ph) are adapted to be biased from the bias voltage source (+V) by means of the line selector (CA), each via individual resistances (RF, RC), one of which (RF) is connected as a negative feedback resistance in the amplifier (PA) following the respective photodetector.

3. An opto-electronic selector according to one of claims 1 and 2, characterized in that each of said amplifiers (PA) has several stages powered by individual branches of a current mirror (MC) constituting the current source for the respective amplifier.

4. An opto-electronic selector according to claim 3, characterized in that the current mirror (MC) associated with each amplifier is activated by a switching transistor (Tc) which is biased from the bias voltage source (+V) by means of the line selector (CA) and which is controlled by the bias voltage source (+V) by means of the column selector (CA).

FIG.1

EP 0 168 631 B1

FIG.2

EP 0 168 631 B1